# EUROPEAN PATENT APPLICATION

(11) **EP 2 542 036 A1**
(43) Date of publication of application: **02.01.2013**
(21) Application number: 12170952.1
(22) Date of filing: 06.06.2012
(51) Int. Cl.: H05K 1/11, H05K 13/04, H05K 3/36, H05K 1/14, H05K 3/34

(54) **Machine placeable circuit board interposer**

(30) Priority: 28.06.2011 US 201113170959
(71) Applicant: Delphi Technologies, Inc., Troy, MI 48007 (US)
(72) Inventor: Visser, Roy A., Greentown, IN Indiana 46936 (US); Vadas, Robert L., Noblesville, IN Indiana 46060 (US); Gilbertson, Kurt E., Peru, IN Indiana 46970 (US); Pepples, Michael J., Noblesville, IN Indiana 46060 (US)
(74) Representative: Denton, Michael John

(57) **Abstract**

An interposer (30) for connecting two or more circuit boards (22, 26) is a circuit carrying substrate (32) with two or more solder pads (40, 44) on each of two sides (34, 36). Each of the solder pads (40, 44) are connected (42) to an electrically conductive via (38) in the substrate (32), providing electrical interconnection from one side (34) to the other side (36). One or more solder pads (40, 44) have a solder ball (46) on it. The interposer (30) has a contact area (48) suitable for the interposer (30) to be picked up and placed by an automated part placement machine (50). An electrical assembly (20) is made by soldering the solder balls (46) on one side (34) of the interposer (30) to corresponding solder pads (24) on a circuit board (22). The solder balls (46) on the other side (36) of the interposer (30) are likewise soldered to the corresponding solder pads (28) of a second circuit board (26).

## Description

### TECHNICAL FIELD

The invention generally relates to electrical connectors, and more particularly relates to circuit board interposers.

### BACKGROUND OF THE INVENTION

Interposers in the form of double sided ball grid arrays are known in the art. Installing an interposer into an electrical assembly using an automated part placement machine may require specialized handling equipment and fixtures. Edge handling or gripper mechanisms typically used to place an interposer onto the circuit board are usually unique to each interposer and may be expensive. Gripper mechanisms also require a dedicated location in the automated part placement machine to store trays or tubes of interposers awaiting installation which may limit the part handling capacity of the machine.

### SUMMARY OF THE INVENTION

In accordance with one embodiment of this invention, a circuit board interposer is provided. The interposer is a circuit carrying substrate with two or more solder pads on each of the two sides. Each of the solder pads are connected to an electrically conductive via in the substrate, providing electrical interconnection from one side to the other side. One or more solder pads has a solder ball on it. The interposer has a contact area suitable for the interposer to be picked up and placed by an automated part placement machine.

In another embodiment of the present invention, an electrical assembly is provided by soldering the solder balls on one side of the interposer to corresponding solder pads on a circuit board. The solder balls on the other side of the interposer are likewise soldered to the corresponding solder pads of a second circuit board.

Further features and advantages of the invention will appear more clearly on a reading of the following detailed description of the preferred embodiment of the invention, which is given by way of non-limiting example only and with reference to the accompanying drawings.

### BRIEF DESCRIPTION OF DRAWINGS

The present invention will now be described, by way of example with reference to the accompanying drawings, in which:

Fig. 1 is a view of an electrical assembly comprised of a first circuit board, a second circuit board, and an interposer in accordance with one embodiment

Fig. 2 is detailed view of the interposer in accordance with one embodiment;

Fig 3 is a detailed view of the interposer in accordance with an alternate embodiment wherein one or more solder pads are connected to a plurality of vias;

Fig 4 is a detailed view of the interposer in accordance with an alternate embodiment wherein the solder pads are adjacent to the vias;

Fig. 5 is a detailed view of a vacuum pick and place tool and the contact area of the interposer.

Fig. 6 is a view of an electrical assembly comprised of a first circuit board, a second circuit board, and an interposer in accordance with an alternate embodiment providing a mounting location for any fixedly attached electrical component

### DESCRIPTION OF THE PREFERRED EMBODIMENT

The interposer disclosed herein offers several benefits not found in the prior art. The interposer is adapted to be installed in an electrical assembly using an automated part placement machine without the need for specialized handling equipment such as edge handling or gripper mechanisms. The interposer may be installed by an automated part placement machine using a vacuum pick and place tool. The interposer may also be packaged in a standard tape and reel to further simplify the handling of the interposer by the automated part placement machine, by eliminating the need to package the interposer in a matrix tray or tube. Matrix trays or tubes may require more operator attention when using an automated part placement machine that when using tape and reel packaging.

Additionally, the solder pads that form the electrical contacts between the interposer and the circuit board may be arranged in a rectangular array to maximize the number of electrical connections provided in the circuit board area occupied by the interposer.

While the specification concludes with claims defining the features of the invention that are regarded as novel, it is believed that the invention will be better understood from a consideration of the following description in conjunction with the drawing figures, in which like reference numerals are carried forward.

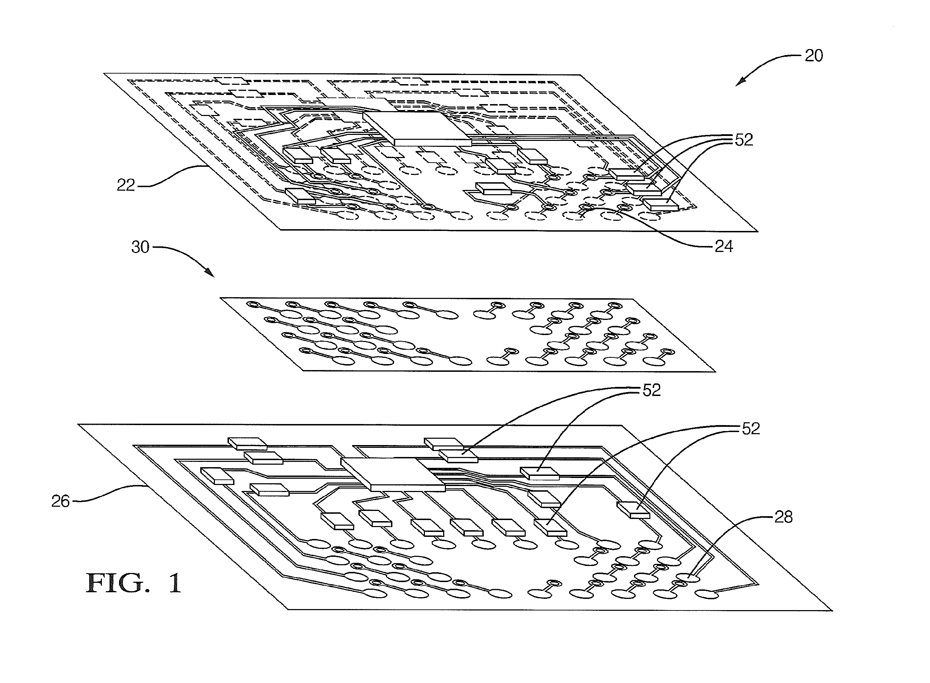

In accordance with an embodiment of an electrical assembly 20, Fig. 1 illustrates a first circuit board 22 having a first arrangement of solder pads 24, a second circuit board 26 having a second arrangement of solder pads 28, and an interposer 30. The circuit boards 22, 26 may be made from epoxy or polyimide resins. The resin may be reinforced with a woven glass cloth or other matrix such as chopped fibers. Circuit boards formed of such materials are commonly called FR-4 or G-10 type circuit boards. The first and second circuit boards 22, 26 may alternately be constructed of ceramic, rigid or flexible polymers. This listing of acceptable circuit board materials is not exhaustive and other materials may also be used successfully. The first circuit board 22 and the second circuit board 26 do not have to be made of the same material.

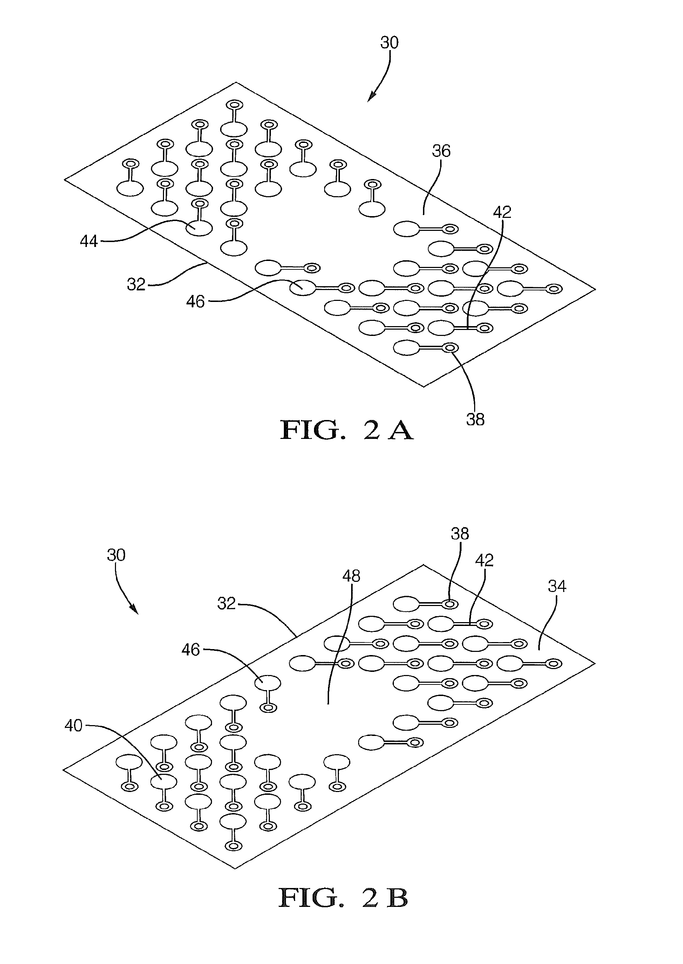

Fig. 2 further illustrates the structure of the interposer 30. The interposer 30 has a plurality of electrically conductive vias 38 providing electrical connections through the substrate 32 between the first major surface 34 and the second major surface 36. A third arrangement of solder pads 40 is arranged on the first major surface 34 of the interposer 30. The location of each solder pad in the third arrangement of solder pads 40 may correspond to the location of a solder pad in the first arrangement of solder pads 24 on the first circuit board 22. Each of the solder pads in the third arrangement of solder pads 40 may be electrically connected to one or more of the electrically conductive vias 38.

A fourth arrangement of solder pads 44 is arranged on the second major surface 36 of the interposer 30. The location of each solder pad in the fourth arrangement of solder pads 44 may correspond to the location of a solder pad in the second arrangement of solder pads 28 on the second circuit board 26. Each of the solder pads in the fourth arrangement of solder pads 44 may be electrically connected to one or more of the electrically conductive vias 38 and to one or more solder pads in the third arrangement of solder pads 40.

The interposer 30 may be made using a substrate 32, such as that used in the industry for conventional circuit boards. The substrate 32 defines a first major surface 34 and a second major surface 36 opposite the first major surface 34. The interposer 30 can be formed of almost any material capable of supporting the vias 38 and solder pads 40, 44, including, but not limited to, FR-4, G-10, ceramic, rigid or flexible polymer. Typically, the material used for the interposer 30 is the same material used in the first and second circuit boards 22, 26 that are to be interconnected. This provides an advantage of reducing the stresses between the first and second circuit boards 22, 26 and the interposer 30, as will be explained later. However, it is not necessary that the interposer 30 be made from the exact same material as the circuit board, for example, epoxy circuit boards may be connected using a polyimide interposer or vice versa.

The solder pads 40, 44 may be formed in a conventional manner, for example, by subtractive processing of copper clad materials. The reader will appreciate that a pattern of solder pads may take many forms, and need not be limited to the configuration shown in the drawing.

The vias 38 may be a plated through hole in the substrate 32. The plated through hole typically passes straight through the substrate 32, but other via constructions such as blind or buried vias that only extend part way through may also be successfully used. In these cases, the interconnection is completed by using another blind or buried via connected to an inner layer of circuitry in the substrate 32, making the interposer a three layer configuration. The inner layer may also be used as a ground layer, providing an electromagnetic shielding effect for the first and second circuit boards 22, 26.

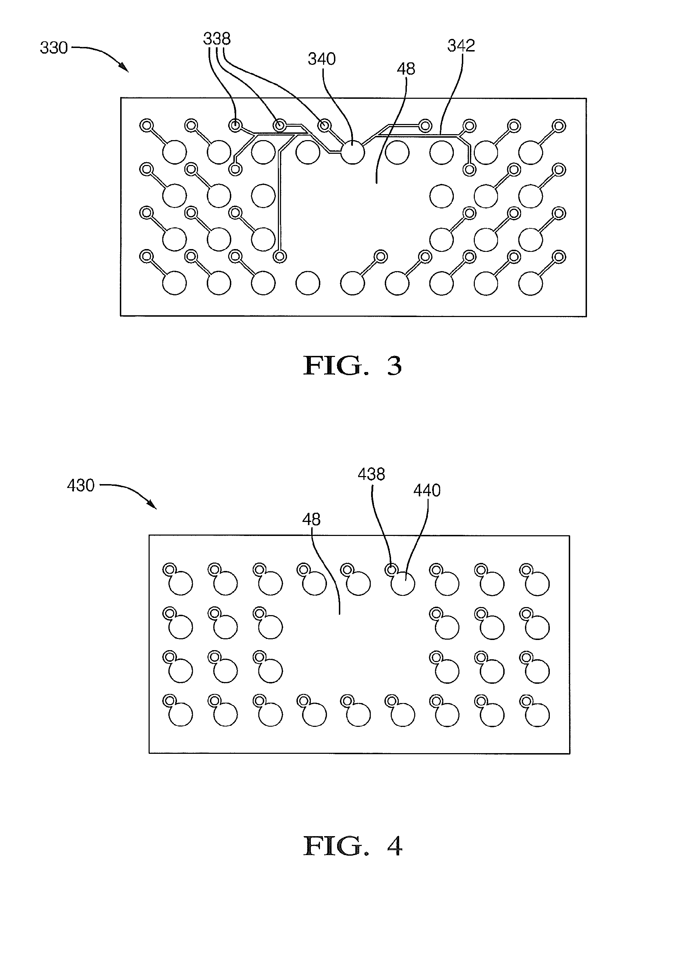

Fig. 2 shows that the solder pad 40, 44 may be offset from the via 38, and may be connected to the via 38 by a conductive trace 42. In an alternate embodiment of the interposer 330 illustrated in Fig. 3, one or more solder pads in the third arrangement of solder pads 340 may be connected to multiple vias 338 by multiple conductive traces 342 forming a fin out or fan in configuration. Thus a single solder pad in the third arrangement of solder pads 340 may be connected to multiple solder pads in the fourth arrangement of solder pads (not shown). Other via configurations, such as the solder pad located directly on top of the via or the solder pad 440 adjacent to the via 438 as shown in Fig. 4 may also be used and still fall within the scope of the invention. Some solder pads 40, 44 may not be connected to a via, but may be used solely to establish a mechanical connection between the interposer 30 and the first or second circuit boards 22, 26.

In order to use one embodiment of the interposer 30 in multiple variations of the electrical assembly 20, it may be advantageous for some of the solder pads 40, 44 on the interposer 30 to be unconnected to the first or second circuit boards 22, 26 so that one embodiment of the interposer 30 may be used with multiple electrical assemblies 20 where the first and second circuit boards 22, 26 may have different solder pad arrangements. Alternately, it may be advantageous to configure the interposer so that the connections between the solder pads in the third arrangement of solder pads 40 and the solder pads in the fourth arrangement of solder pads 44 may differ from those of another embodiment of the interposer such that a different set of connections are made between the first and second circuit boards 22, 26.

Although the interposer 30 is shown in the figures as a rectangular part, the reader will readily appreciate that it could be made in many different shapes, for example a "C", "H", or "L" shape.

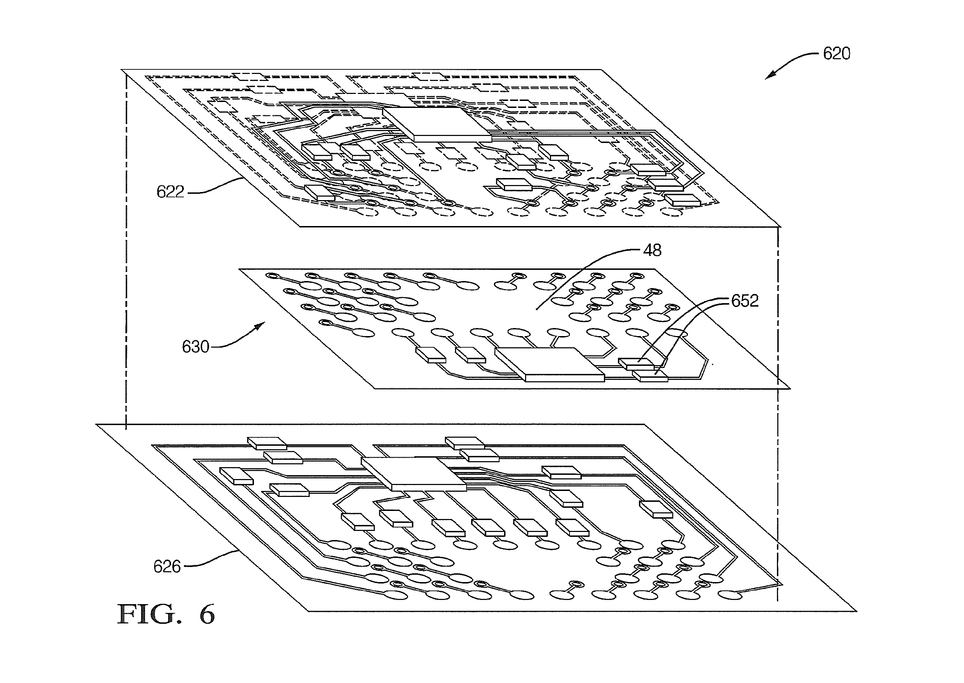

In an alternate embodiment shown in Fig. 6, an electrical assembly 620 may be configured so that a portion of the interposer 630 is not intermediate to the first and second circuit boards 622, 626. The non-intermediate portion may provide a mounting location for electrical components 652 such as a connector, fuse, memory socket, or any fixedly attached component.

Solder balls 46 may be placed on one or more of the solder pads in each of the third and fourth arrangement of solder pads 40, 44. The solder balls 46 provide the electrical and mechanical connection between the first and second circuit boards 22, 26. The solder balls 46 may be formed using any number of methods such as printing solder paste, using solder performs, by plating or cladding solder, or by depositing solder spheres on the pads. In each of the methods, the solder material may be reflowed to ensure that the solder material is firmly adhered to the underlying copper pad. After reflow, the solder material usually assumes the shape of a modified sphere.

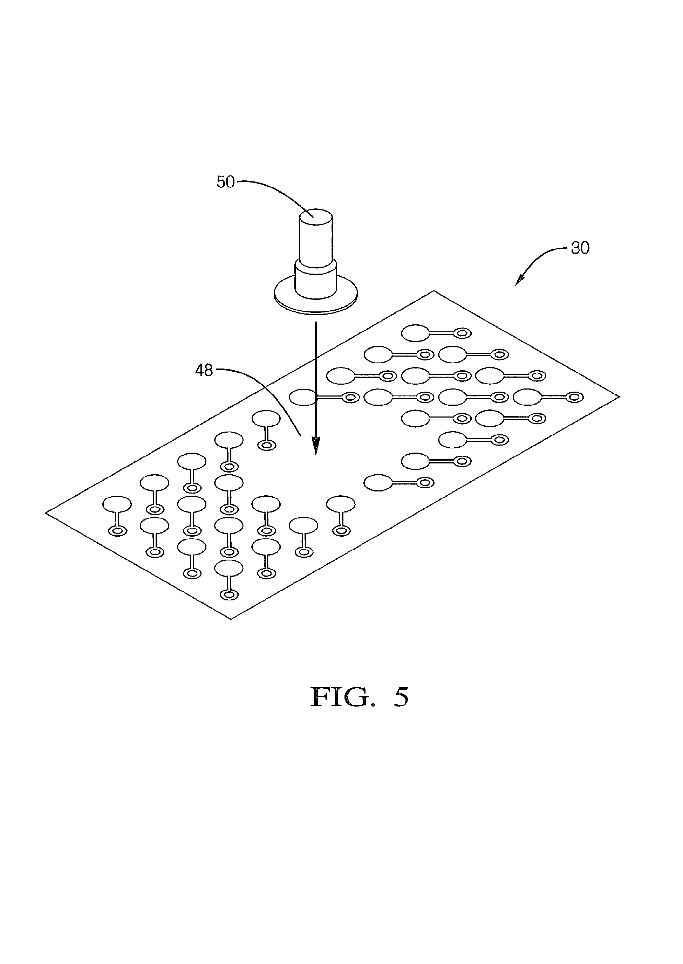

The interposer 30 may define a contact area 48 on the interposer 30 suitable for the interposer 30 to be picked up and placed by an automated part placement machine (not shown). The contact area 48 is generally free of solder pads included in the third arrangement of solder pads 40 or the fourth arrangement of solder pads 44 so a vacuum pick and place tool 50 (See Fig. 5) may securely hold the interposer 30. The contact area 48 may allow the vacuum pick and place tool 50 to pick-up and place the interposer 30 onto the first or second circuit board 22, 26 without specialized handling equipment or fixtures. The contact area 48 may also facilitate placement of the interposer 30 using a hand tool equipped with a vacuum head to manually pick and place the interposer 30.

The first circuit board 22, the second circuit board 26, and the interposer 30 may be joined by reflowing the solder balls 46. The solder balls 46 on the first major surface 34 of the interposer 30 are aligned to the solder pads 24 on the first circuit board 22 and are reflowed. Each of the solder balls 46 on the second major surface 36 of the interposer 30 is also aligned to one of the solder pads 28 on the second circuit board 26 and reflowed. This arrangement provides a direct and robust electrical and mechanical connection between each of the solder pads 24 on the first circuit board 22 and each of the solder pads 28 on the second circuit board 26. It may be seen that one advantage of this type of configuration is that the interposer 30 may also provide structural rigidity to the assembled structure, and may also hold the first and second circuit board 22, 26 in fixed alignment.

More than two circuit boards may be connected into an electrical assembly 20 using the interposer 30. For example, three circuit boards may be vertically connected using two interposers. The concept may be further extended to connect many circuit boards together vertically. By using an interposer 30 made from materials similar to the circuit boards, the thermal expansion or contraction of each of the members of the electrical assembly 20 is similar, thus ameliorating the problems caused by stress resulting from dissimilar thermal expansion characteristics. It will be appreciated that if the materials are not similar, the rigid construction of the present invention would result in significant stress between each member.

It will be appreciated that the number of connections between the first and second circuit board 22, 26 may be increased by using additional interposers. The interposers may be placed in an array on the first and second circuit board 22, 26 or may be placed singly in various locations on the first and second circuit board 22, 26.

The contact area 48 may be suitable for the interposer 30 to be picked up and placed by a vacuum pick and place tool 50 of the automated part placement machine. The contact area 48 is generally free of plated through hole vias 38 or any other features that may not allow the vacuum pick and place tool 50 to develop sufficient vacuum to allow the automated part placement machine to pick up the interposer 30.

The contact area 48 may be centrally located on the first major surface 34. Centrally located may be interpreted to mean located near the geometric center of the first major surface 34, near the center of gravity of the interposer 30, or any place on the first major surface 34 that will cause a minimal rotational stress to be placed on the vacuum pick and place tool 50.

Designation of the first and second major surface 34, 36 is arbitrary. It can be appreciated that the contact area 48 could alternately be located on the second major surface 36. In alternate embodiment of the interposer 30, the contact area 48 could be located on both the first and second major surface 34, 36.

The interposer 30 may be sized to fit into a tape and reel package. Tape and reel is a method of packaging surface mount electrical components by loading them into individual pockets comprising what is known as a pocket tape or carrier tape. The interposers are sealed in the carrier tape with a cover tape, usually by heat or pressure. The carrier tape is typically wound around a reel for convenient handling and transport. The use of the tape and reel package makes the number of connections between the first and second circuit boards 22, 26 scalable, additional interposers are easily placed on the first and second circuit boards 22, 26 to provide additional board to board connections.

The interposer 30 may be constructed so that the third arrangement of solder pads 40 and the fourth arrangement of solder pads 44 are arranged in a rectangular array. The solder pads 40, 44 are arranged in a rectangular array to maximize the number of connections contained on the area of the first and second major surfaces 34, 36 of the interposer 30.

According to one embodiment, the center to center spacing of the solder pads 40, 44 in the rectangular array may be greater than or equal to 1.9 mm. It may be preferable that the center to center spacing of the solder pads 40, 44 be larger than the diameter of the solder balls 46 so the solder balls 46 don't melt together during reflow. However it may be recognized that large solder joints may be created by placing solder balls 46 close enough together so that they do melt together during reflow. The center to center spacing of the solder pads 40, 44 in the rectangular array determines the size of the test probes that may be used for in-circuit testing. Smaller center to center spacing requires smaller test probes and test probe reliability decreases as test probe size decreases.

The interposer 30 may be advantageously constructed with solder balls 46 having a diameter greater than or equal to 1.6 mm. Large diameter solder balls increase the current carrying capability of the solder balls 46. A larger cross section and vertical height of the solder balls 46 may also provide low solder strain in the resulting solder joints thereby providing solder joints capable of surviving many power and temperature cycles. Furthermore, large solder balls create a gap sufficient to place electrical components 52 (e.g. surface mount capacitors, resistors, semiconductor devices) on the surfaces of the first and second circuit boards 22, 26 connected by the interposer 30. If smaller solder balls are used, insufficient space may exist to allow parts to be placed on the surfaces of the first and second circuit boards 22, 26 connected by the interposer 30 restricting the placement of electrical components to the surfaces of the first and second circuit boards 22, 26 not connected by the interposer 30. Limiting electrical component placement to one side of the first and second circuit boards 22, 26 will cause the first and second circuit boards 22, 26 to be larger than they would be if electrical components may be placed on both sides of the first and second circuit boards 22, 26. Therefore, the large diameter solder balls 46 enable smaller and cheaper electrical assemblies.

The interposer 30 may be constructed so that the third arrangement of solder pads 40 and the fourth arrangement of solder pads 44 are in one to one alignment. Thus, each solder pad in the third arrangement of solder pads 40 on the first major surface 34 is generally above a corresponding solder pad in the fourth arrangement of solder pads 44 on the second major surface 36.

It can be seen that the present invention provides several significant advantages, while eliminating some of the disadvantages of the prior art. By having a dedicated contact area and using tape and reel packaging, the interposer can be assembled into an electrical assembly using an automated part placement machine without the need for specialized part handling equipment. The interposer also allows a high number of electrical connections between circuit boards using a relatively small circuit board area. The interposer may also be scalable, additional interposers may be used to increase the number of connections between the circuit boards.

## Claims

1. An interposer (30) for an electrical assembly (20) having a first circuit board (22) having a first arrangement of solder pads (24) and a second circuit board (26) having a second arrangement of solder pads (28), said interposer (30) comprising:
a substrate (32) defining a first major surface (34) and a second major surface (36) opposite the first major surface (34);
a plurality of electrically conductive vias (38) providing electrical connections through the substrate (32) between the first major surface (34) and the second major surface (36);
a third arrangement of solder pads (40) arranged on the first major surface (34) in a first pattern corresponding to the first arrangement of solder pads (24), one or more of said third arrangement of solder pads (40) are electrically connected to an electrically conductive via (38);
a fourth arrangement of solder pads (44) arranged on the second major surface (36) in a second pattern corresponding to the second arrangement of solder pads (28), one or more of said fourth arrangement of solder pads (44) are electrically connected to one or more of the electrically conductive vias (38) and to one or more of the third arrangement of solder pads (40); and
a solder ball (46) on one or more of the pads in each of said third arrangement of solder pads (40) and said fourth arrangement of solder pads (44), wherein the interposer (30) defines a contact area (48) on the interposer (30) suitable for the interposer (30) to be picked up and placed by a vacuum pick and place tool (50).

2. The interposer (30) of claim 1, wherein the contact area (48) is centrally located on the first major surface (34).

3. The interposer (30) of claim 1, wherein the interposer (30) is sized and shaped to fit into a tape and reel package.

4. The interposer (30) of claim 1 wherein the third arrangement of solder pads (40) on the first major surface (34) of the interposer (30) and the fourth arrangement of solder pads (44) on the second major surface (36) of the interposer (30) are arranged in a rectangular array.

5. The interposer (30) of claim 4, wherein the rectangular array is characterized as having a center to center spacing is greater than or equal to 1.9 mm.

6. The interposer (30) of claim 1, wherein a diameter of the solder ball (46) is greater than or equal to 1.6 mm.

7. The interposer (30) of claim 1 wherein the third arrangement of solder pads (40) and the fourth arrangement of solder pads (44) are in one to one alignment.

8. An electrical assembly (20), comprising:
a first circuit board (22) having a first arrangement of solder pads (24);
a second circuit board (26) having a second arrangement of solder pads (28) and;
an interposer (30), that further comprises;
a substrate (32) defining a first major surface (34) and a second major surface (36) opposite the first major surface (34);
a plurality of electrically conductive vias (38) providing electrical connections through the substrate (32) between the first major surface (34) and the second major surface (36);
a third arrangement of solder pads (40) arranged on the first major surface (34) in a first pattern corresponding to the first arrangement of solder pads (24), each of said third arrangement of solder pads (40) electrically connected to an electrically conductive via (38);
a fourth arrangement of solder pads (44) arranged on the second major surface (36) in a second pattern corresponding to the second arrangement of solder pads (28), each of said fourth arrangement of solder pads (44) electrically connected to one or more of the electrically conductive vias (38) and to one or more of the third arrangement of solder pads (40); and
a solder ball (46) on one or more of the pads in each of said third arrangement of solder pads (40) and said fourth arrangement of solder pads (44), wherein the first circuit board (22), the second circuit board (26), and the interposer (30) are joined by reflowing the solder balls (46), wherein the interposer (30) defines a contact area (48) on the interposer (30) suitable for the interposer (30) to be picked up and placed by a vacuum pick and place tool (50).

9. The electrical assembly (20) of claim 8, wherein the contact area (48) is centrally located on the first major surface (34).

10. The electrical assembly (20) of claim 8, wherein the interposer (30) is sized and shaped to fit into a tape and reel package.

11. The electrical assembly (20) of claim 8, wherein the third arrangement of solder pads (40) on the first major surface (34) of the interposer (30) and the fourth arrangement of solder pads (44) on the second major surface (36) of the interposer (30) are arranged in a rectangular array.

12. The electrical assembly (20) of claim 11, wherein the rectangular array is characterized as having a center to center spacing is greater than or equal to 1.9 mm.

13. The electrical assembly (20) of claim 8, wherein a diameter of the solder ball (46) is greater than or equal to 1.6 mm.

14. The electrical assembly (20) of claim 8 wherein the third arrangement of solder pads (40) and the fourth arrangement of solder pads (44) are in one to one alignment.
